# EUROPÄISCHE PATENTANMELDUNG

(11) **EP 2 251 979 A1**
(43) Veröffentlichungstag der Anmeldung: **17.11.2010**
(21) Anmeldenummer: 09159930.8
(22) Anmeldetag: 11.05.2009
(51) Int. Cl.: H03K 17/16, H02M 1/08, H03K 17/04, H03K 17/0412

(54) **Verfahren und Treiberschaltung zum Treiben eines Halbleiterleistungsschalters**

(71) Anmelder: SMA Solar Technology AG, 34266 Niestetal (DE)
(72) Erfinder: Prior, Oliver, 34431, Marsberg (DE); Strubel, Tobias, 34127, Kassel (DE)
(74) Vertreter: Rehberg Hüppe + Partner

(57) **Zusammenfassung**

Zum Schalten eines Halbleiterleistungsschalters (2) in Abhängigkeit von einem digitalen Steuersignal (3), wobei einer Steuerelektrode (4) und einer Bezugselektrode (5) des Halbleiterleistungsschalters (2) jeweils einer von zwei Polen (9,10) einer Treiberversorgungsspannungsquelle (8) zugeschaltet wird, wird aufgrund jeder Änderung des digitalen Steuersignals (3) die Zuschaltung der beiden Pole (9,10) der Treiberversorgungsspannungsquelle (12) zu der Steuerelektrode (4) einerseits und der Bezugselektrode (5) andererseits umgekehrt (7,6,11).

## Beschreibung

### TECHNISCHES GEBIET DER ERFINDUNG

Die Erfindung betrifft ein Verfahren zum Schalten eines Halbleiterleistungsschalters mit den Merkmalen des Oberbegriffs des unabhängigen Patentanspruchs 1 sowie eine Treiberschaltung zur Durchführung dieses Verfahrens mit den Merkmalen des Oberbegriffs des nebengeordneten Patentanspruchs 10.

Bei dem Halbleiterleistungsschalter, für den die vorliegende Erfindung vorgesehen ist, handelt es sich um ein spannungsgesteuertes Bauelement, wie beispielsweise einen IGBT oder Feldeffekttransistor. Dabei kann der Halbleiterleistungsschalter ohne Ansteuerung seiner Steuerelektrode sowohl selbstsperrend als auch selbstleitend sein, auch wenn in der folgenden Beschreibung teilweise nur auf selbstsperrende Halbleiterleistungsschalter eingegangen wird. Insbesondere ist die vorliegende Erfindung für einen schnell schaltenden Halbleiterteistungsschalter vorgesehen, der hochfrequent taktbar ist.

### STAND DER TECHNIK

In vielen leistungselektronischen Schaltungen werden Halbleiterleistungsschalter eingesetzt, die ohne eine Spannung an ihrer Steuerelektrode gesperrt sind und durch das Anlegen einer Steuerspannung an ihre Steuerelektrode leitend werden (oder umgekehrt). Bei Halbleiterleistungsschaltern mit isolierter Steuerelektrode, wie beispielsweise MOSFET oder IGBT, sind Steuerspannungen im Bereich von 10 bis 15 Volt gebräuchlich.

Soll der Halbleiterleistungsschalter gesperrt werden, genügt es in einigen Anwendungen, die Steuerelektrode spannungslos zu schalten. Dies ist besonders vorteilhaft, weil dann nur eine einzige Treiberversorgungsspannung bereitgestellt werden muss. Dies kann vielfach über eine einfache Bootstrap-Schaltung realisiert werden.

Wird der Halbleiterleistungsschalter zum Beispiel in einer Brückenschaltung betrieben, d. h. in einer Halb- oder Vollbrücke, ist es jedoch häufig erforderlich, an seine Steuerelektrode eine Potenzialdifferenz in umgekehrter Richtung anzulegen, um ihn auch bei transienten Vorgängen sicher im gesperrten Zustand zu halten. Kommerziell verfügbare integrierte Treiberschaltungen sind im Allgemeinen für Betriebsspannungen von 15 bis 20 Volt ausgelegt. Damit ist auch der maximale Ausgangshub für die an die Steuerelektrode anlegbare Spannung entsprechend begrenzt.

Wird für die Ansteuerung eines Halbleiterleistungsschalters ein höherer Spannungshub benötigt, kann der Treiber grundsätzlich mit diskreten, entsprechend spannungsfesten Bauteilen aufgebaut werden. Alternativ kann die Spannung mit Hilfe eines Steuerspannungsübersetzers transformatorisch auf einen höheren Pegel umgesetzt werden. Beide Lösungen sind mit einem erheblichen Aufwand verbunden. Die letztgenannte Lösung ist zudem nicht zur Erzeugung statischer Spannungen an der Steuerelektrode des Halbleiterleistungsschalters geeignet.

Aus der DE 37 18 001 A1 ist eine Schaltungsanordnung zur Erzeugung bipolarer digitaler Datensignale aus unipolaren Datensignalen bekannt, die einen Schaltungsausgang in Abhängigkeit von den unipolaren Datensignalen mit dem positiven oder dem negativen Anschluss einer unipolaren Spannungsquelle verbindet. Hierzu weist die Schaltungsanordnung eine durch Inverter gebildete Schalterkombination auf.

### AUFGABE DER ERFINDUNG

Der Erfindung liegt die Aufgabe zugrunde, ein Verfahren zum Schalten eines Halbleiterleistungsschalters und eine entsprechende Treiberschaltung aufzuzeigen, die mit geringem Aufwand in der Lage sind, den Halbleiterleistungsschalter auch bei transienten Vorgängen in dem jeweils gewünschten Zustand zu halten. Gleichzeitig ist die Möglichkeit der Verwendung handelsüblicher integrierter Treiberschaltungen gewünscht, um bei kompaktem Aufbau die in diese integrierten Schutz- und Überwachungsfunktionen nutzen zu können.

### LÖSUNG

Die Aufgabe der Erfindung wird durch ein Verfahren mit den Merkmalen des unabhängigen Patentanspruchs 1 und durch eine Treiberschaltung mit den Merkmalen des nebengeordneten Patentanspruchs 10 gelöst. Bevorzugte Ausführungsformen des neuen Verfahrens und der neuen Treiberschaltung sind in den abhängigen Patentansprüchen definiert.

### BESCHREIBUNG DER ERFINDUNG

Bei der Erfindung besteht kein fester Potenzialbezug zwischen einer Schaltungsmasse des Treibers und der Bezugselektrode des Leistungsschalters. Vielmehr wird die Bezugselektrode, d. h. konkret der Source- oder Emitter-Anschluss, mit dem jeweils anderen Pol der Treiberversorgungsspannung verbunden als die Steuerelektrode. Dies bedeutet, dass aufgrund jeder Änderung des digitalen Steuersignals, mit der eine Änderung des Schaltzustands des Halbleiterleistungsschalters hervorgerufen werden soll, die Zuschaltung der beiden Pole der Treiberversorgungsspannung zu der Steuerelektrode einerseits und der Bezugselektrode andererseits umgekehrt wird. So kann mit Hilfe einer einzigen Treiberversorgungsspannung zwischen den Elektroden des Halbleiterleistungsschalters sowohl eine positive als auch eine negative Potenzialdifferenz erzeugt werden. Verglichen mit dem Stand der Technik ergibt sich bei gleicher Spannungsbelastung der verwendeten Bauteile ein doppelter Spannungshub.

Das neue Verfahren zum Schalten eines Halbleiterleistungsschalters wird bei der neuen Treiberschaltung mit zwei Halbbrücken, d. h. einer Vollbrücke, umgesetzt, die die Steuerelektrode und die Bezugselektrode des Halbleiterleistungsschalters jeweils wechselweise mit den beiden Polen der Treiberversorgungspannung verbinden. Dabei kann die Brückenschaltung aus diskreten Bauteilen aufgebaut sein. Es kann sich aber auch um zwei handelsübliche integrierte Treiberbausteine oder einen beide Halbbrücken realisierenden Doppeltreiber handeln.

In der praktischen Umsetzung der vorliegenden Erfindung erweist es sich als verhältnismäßig aufwändig, genau gleiche Schaltzeitpunkte für das Umschalten beider Elektroden des Halbleiterleistungsschalters zwischen den beiden Polen der Treiberversorgungsspannung zu realisieren. Unterschiedliche Schaltzeitpunkte führen dazu, dass die Potenzialdifferenz zwischen den beiden Elektroden kurzzeitig, d. h. für den Zeitraum zwischen den beiden Umschaltvorgängen, zu null wird. Ein solcher Potenzialverlauf würde zwar für die Ansteuerung der meisten Halbleiterleistungsschalter kein Problem darstellen. In der Praxis wirken sich jedoch parasitäre Induktivitäten und Kapazitäten, beispielsweise in Form von Leitungsinduktivitäten und der Eingangskapazität des Halbleiterleistungsschalters, störend auf den Potenzialverlauf aus. So können durch den zuerst erfolgenden Umschaltvorgang Potenzialschwingungen um die theoretische Potenzialdifferenz von null herum angeregt werden, die im Extremfall den Halbleiterleistungsschalter wiederholt ein- und ausschalten, wenn sie sich bis in den aktiven Schaltbereich des Halbleiterleistungsschalters hinein erstrecken.

Um dieses ungewollte wiederholte Ein- und Ausschalten des Halbleiterleistungsschalters zu unterbinden, das insbesondere bei schnell schaltenden Halbleiterleistungsschaltern auftritt, können die relevanten Leitungsinduktivitäten minimiert werden und/oder kann eine genaue Synchronisation der beiden Umschaltvorgänge beider Elektroden des Halbleiterleistungsschalters zwischen den Polen der Treiberversorgungsspannung durchgeführt werden. Beide Maßnahmen erfordern jedoch einen erheblichen Aufwand, um das gewünschte Ziel tatsächlich zu erreichen.

Bei den bevorzugten Ausführungsformen der vorliegenden Erfindung werden daher die beiden Elektroden unterschiedlich schnell zwischen den beiden Polen der Treiberversorgungsspannung umgeschaltet, so dass der Potenzialübergang an den beiden Elektroden eine unterschiedliche Steilheit aufweist. Konkret wird hierzu jeweils eine der Elektroden so zwischen den beiden Polen der Treiberversorgungsspannung umgeschaltet, dass sich an dieser einen Elektrode ein zeitlich gedehnter stetiger Potenzialübergang ergibt. Dieser zeitlich gedehnte, vorzugsweise lineare Potenzialübergang regt seinerseits in relevantem Umfang keine Potenzialschwingungen an. Er verschiebt jedoch bereits das Potenzial an der einen Elektrode des Halbleiterleistungsschalters, so dass die Potenzialdifferenz zwischen den beiden Elektroden des Halbleiterleistungsschalters beim sich anschließenden Umschalten der jeweils anderen Elektrode zwischen den beiden Polen der Treiberversorgungsspannung nicht mehr zu null wird bzw. bei den durch dieses schnelle Umschalten möglicherweise weiterhin angeregten Potenzialschwingungen nicht wiederholt durch den Schaltbereich des Halbleiterleistungsschalters führt.

Dieser Schaltbereich des Halbleiterschalters wird bei der vorliegenden Erfindung mit der Potenzialdifferenz zwischen den beiden Elektroden vielmehr schnell während des weiterhin schnellen Umschaltens der jeweils anderen Elektrode zwischen den beiden Polen der Treiberversorgungsspannung durchfahren.

Die Dauer des zeitlich gedehnten Potenzialübergangs ist bei der vorliegenden Erfindung typischerweise mindestens 5-mal länger als die des schnellen Potenzialübergangs. Sie kann grundsätzlich von etwa 3-mal bis etwa 50-mal länger sein. Bevorzugt ist es aber, wenn sie nicht mehr als 10-mal länger ist, um den gesamten Umschaltvorgang in immer noch möglichst kurzer Zeit abzuschließen.

Damit der weiterhin schnelle Potenzialübergang beim Umschalten der jeweils anderen Elektrode zwischen den Polen der Treiberversorgungsspannung immer während des zeitlich gedehnten Potenzialübergangs an der einen Elektrode des Halbleiterleistungsschalters erfolgt, wird bei der vorliegenden Erfindung der Beginn des kürzeren Potenzialübergangs gegenüber dem Beginn des zeitlich gedehnten Potenzialübergangs verzögert. Diese Verzögerung beträgt typischerweise mindestens 10 % und maximal 90 % der Dauer des zeitlich gedehnten Potenzialübergangs. Vorzugsweise liegt der Beginn des kürzeren Potenzialübergangs in einem Fenster von 20 bis 80 % der Dauer des zeitlich gedehnten Potenzialübergangs.

Soweit der jeweilige Halbleiterleistungsschalter - was der Regelfall ist - keinen Schaltbereich bei einer Potenzialdifferenz zwischen den beiden Elektroden von null, sondern bei einer hiervon abweichenden positiven (oder negativen) Spannung aufweist, ist es nicht bevorzugt, dass die zeitliche Abfolge zwischen dem Beginn des jeweils zeitlich gedehnten Potenzialübergangs und des kürzeren Potenzialübergangs für beide Richtungen des Umschaltens der Elektroden des Leistungsarbeiterschalters zwischen den beiden Polen der Treiberversorgungsspannung identisch ist. Vielmehr erweist sich eine unterschiedliche Verzögerung in Abhängigkeit von der Schaltrichtung als vorteilhaft, um mit der Potenzialdifferenz zwischen den beiden Elektroden den Schaltbereich des Halbleiterleistungsschalters jeweils während des kürzeren Potenzialübergangs an der jeweils anderen Elektrode zu durchfahren.

Bei der konkreten Umsetzung der Erfindung kann es sich als sinnvoll erweisen, dass die eine Elektrode, an der für einen zeitlich gedehnten Potenzialübergang gesorgt wird, die Steuerelektrode des jeweiligen Halbleiterleistungsschalters ist, während die andere Elektrode, an der ein verzögerter aber schneller Potenzialübergang erfolgt, die Bezugselektrode des Halbleiterleistungsschalters ist.

Wie bereits angedeutet wurde, können die Halbbrücken der neuen Treiberschaltung, mit der das erfindungsgemäße Verfahren umgesetzt wird, auf unterschiedliche Weise ausgebildet sein. Konkrete Ausführungsbeispiele werden in der folgenden Figurenbeschreibung erläutert.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

### KURZBESCHREIBUNG DER FIGUREN

Die Erfindung wird im Folgenden anhand von Ausführungsbeispielen unter Bezugnahme auf die beigefügten Zeichnungen näher erläutert und beschrieben.
- **Fig. 1**: zeigt ein Prinzipschaltbild zu einer ersten Ausführungsform der neuen Treiberschaltung.
- **Fig. 2**: zeigt ein Prinzipschaltbild zu einer zweiten Ausführungsform der neuen Treiberschaltung.
- **Fig. 3**: zeigt beispielhafte theoretische Potenzialverläufe an der Steuerelektrode und der Bezugselektrode eines mit der neuen Treiberschaltung angesteuerten Halbleiterleistungsschalter sowie die resultierende Potenzialdifferenz zwischen den beiden Elektroden für beide Richtungen der Änderung eines digitalen Steuersignals, das mit der Treiberschaltung umgesetzt wird.
- **Fig. 4**: skizziert die bei der Treiberschaltung gemäß Fig. 1 vorhandenen parasitären Induktivitäten sowie die Eingangskapazität des Halbleiterleistungsschalters.
- **Fig. 5**: zeigt in einer Fig. 3 entsprechenden Darstellung die Auswirkung der parasitären Elemente gemäß Fig. 4 auf die Potenzialverläufe.
- **Fig. 6**: zeigt in einer den Fig. 3 und 5 entsprechenden Darstellung bei der vorliegenden Erfindung bevorzugte Potenzialverläufe und die resultierende Potenzialdifferenz zwischen den beiden Elektroden des Halbleiterleistungsschalters; und
- **Fig. 7**: skizziert eine konkretere Umsetzung der neuen Treiberschaltung zur Realisierung der bevorzugten Potenzialverläufe.

### FIGURENBESCHREIBUNG

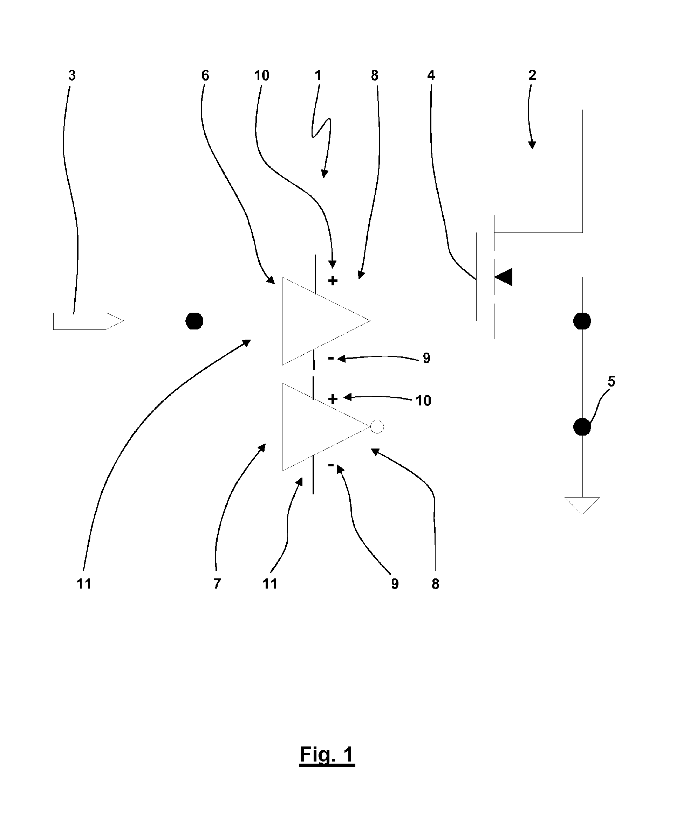

Die in **Fig.1** skizzierte Treiberschaltung 1 dient zum Schalten eines hier als MOSFET angedeuteten Halbleiterleistungsschalters 2 in Abhängigkeit von einem digitalen Steuersignal 3. Dazu legt die Treiberschaltung 1 zwischen einer Steuerelektrode 4 des Halbleiterleistungsschalters 2, dem Gate des MOSFET, und einer Bezugselektrode 5 des Halbleiterleistungsschalters 2, der Source des MOSFET, eine Potenzialdifferenz an. Diese Potenzialdifferenz wird mit zwei Treiberbausteinen 6 und 7 aus einer einzigen Treiberversorgungsspannung 8 generiert, indem die beiden Pole der Treiberversorgungsspannung 8 wechselweise an die beiden Elektroden 4 und 5 angelegt werden. Dabei ist der Treiberbaustein 7 mit einer Invertierung versehen. Die Potenzialdifferenz zwischen den Elektroden 4 und 5 entspricht so bei dem einen Wert des digitalen Steuersignals 3 der Treiberversorgungsspannung und bei dem anderen Wert des digitalen Steuersignals 3 der Treiberversorgungsspannung mit umgekehrtem Vorzeichen. Anders gesagt, ist der Spannungshub der Potenzialdifferenz zwischen den Elektroden 4 und 5 durch die Treiberschaltung 1 gegenüber der Treiberversorgungsspannung 8 verdoppelt.

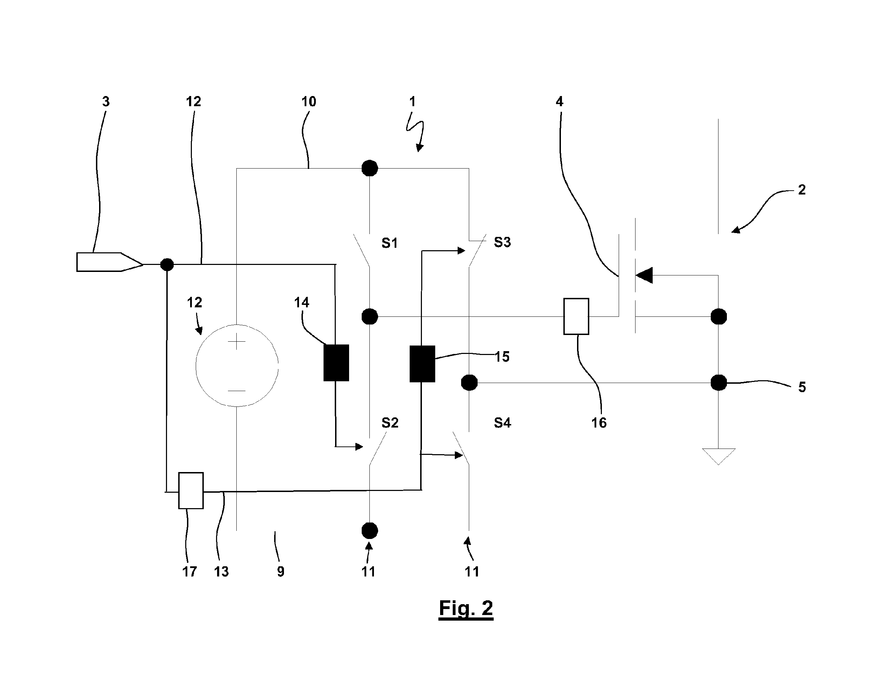

Jeder der Treiberbausteine 6 und 7 gemäß Fig. 1 bildet eine Halbbrücke 11 zwischen den Polen 9 und 10 der Treiberversorgungsspannung 8 aus. Dies wird an **Fig. 2** deutlich, die eine Ausführungsform der Treiberschaltung 1 zeigt, bei der die Halbbrücken 11 zur Verdeutlichung jeweils als diskrete Schalter S1 und S2 bzw. S3 und S4 dargestellt sind, die die Elektroden 4 und 5 wechselweise mit den beiden Polen 9 und 10 einer Treiberversorgungsspannungsquelle 12 verbinden. In Fig. 2 ist dargestellt, dass die Schalter S2 und S3 geschlossen sind, während die Schalter S1 und S4 offen sind. Damit liegt die Steuerelektrode 4 gegenüber der Bezugselektrode 5 auf einem negativen Potenzial. Wenn umgekehrt die Schalter S1 und S4 geschlossen sind, während die Schalter S2 und S3 offen sind, liegt die Steuerelektrode 4 gegenüber der Bezugselektrode 5 auf einem positiven Potenzial. Angesteuert werden die Schalter S1 bis S4 durch Ansteuersignale 12 und 13, die zwischen den Schaltern S1 und S2 bzw. S4 und S3 von einem Invertierer 14 bzw. 15 umgekehrt werden. Das Ansteuersignal 12 ändert seinen Zustand mit dem Steuersignal 3, zwischen den Schaltern S1 und den S2 einerseits und der Steuerelektrode 4 andererseits ist jedoch ein Dehner 16 vorgesehen, der einen Potenzialübergang an der Steuerelektrode 4 infolge eines Umschaltens der Schalter S1 und S2 zeitlich in die Länge zieht, so dass nach jedem Übergang des Steuersignals 3 ein zeitlich gedehnter stetiger Potenzialübergang an der Steuerelektrode 4 erfolgt. Demgegenüber ist für das Ansteuersignal 13 ein Verzögerer 17 vorgesehen, der die Übergänge des Ansteuersignals 13 gegenüber den zugrunde liegenden Übergängen des Steuersignals 3 verzögert. Dadurch erfolgt der Potentialübergang an der Bezugselektrode 5 nach jedem Übergang des Steuersignals 3 zwar verzögert, aber nicht zeitlich gedehnt. Der Sinn dieser Maßnahmen wird im Folgenden näher erläutert.

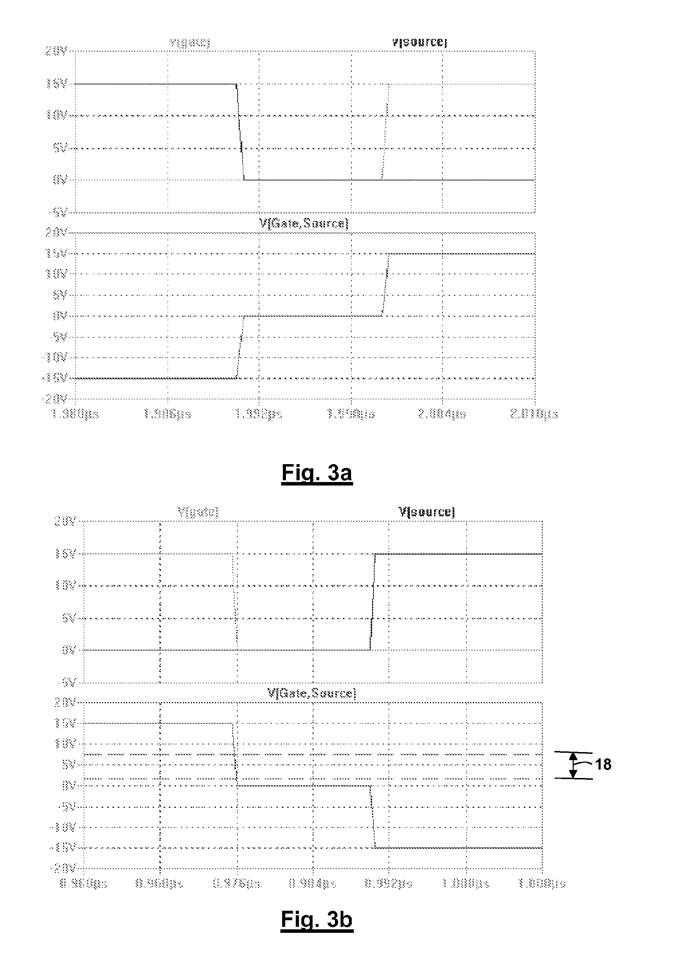

**Fig. 3** skizziert die theoretischen Potenzialverläufe an der Steuerelektrode 4 (Gate) und der Bezugselektrode 5 (Source) sowie die resultierende Potenzialdifferenz zwischen den Elektroden 4 und 5 (Gate-Source) bei einem theoretischen Einschaltvorgang (a)) und einem theoretischen Ausschaltvorgang (b)) mit der Treiberschaltung 1 gemäß Fig. 1. Die Potenzialübergänge an den beiden Elektroden 4 und 5 erfolgen nicht exakt zur selben Zeit. Vielmehr ist der Potenzialübergang an der Bezugselektrode 5 (Source) gegenüber dem Potenzialübergang an der Steuerelektrode 4 (Gate) leicht verzögert. Hierdurch ergibt sich in der Zwischenzeit eine Potenzialdifferenz zwischen den Elektroden (Gate-Source) von null. Dies ist bei den dargestellten Potenzialverläufen angesichts eines Schaltbereichs 18 des Halbleiterleistungsschalters 2 gemäß Fig. 1 um eine positive Potenzialdifferenz von etwa 5 Volt unkritisch.

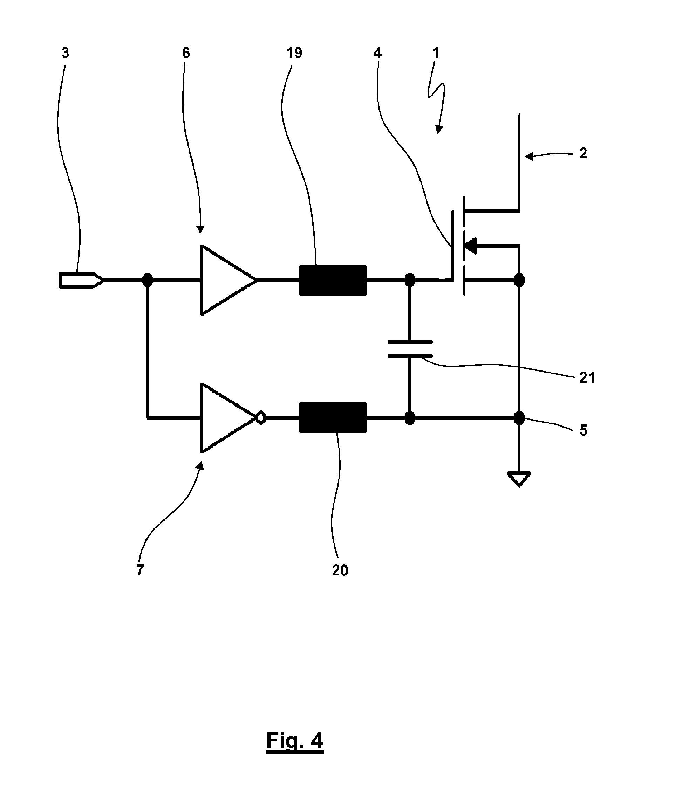

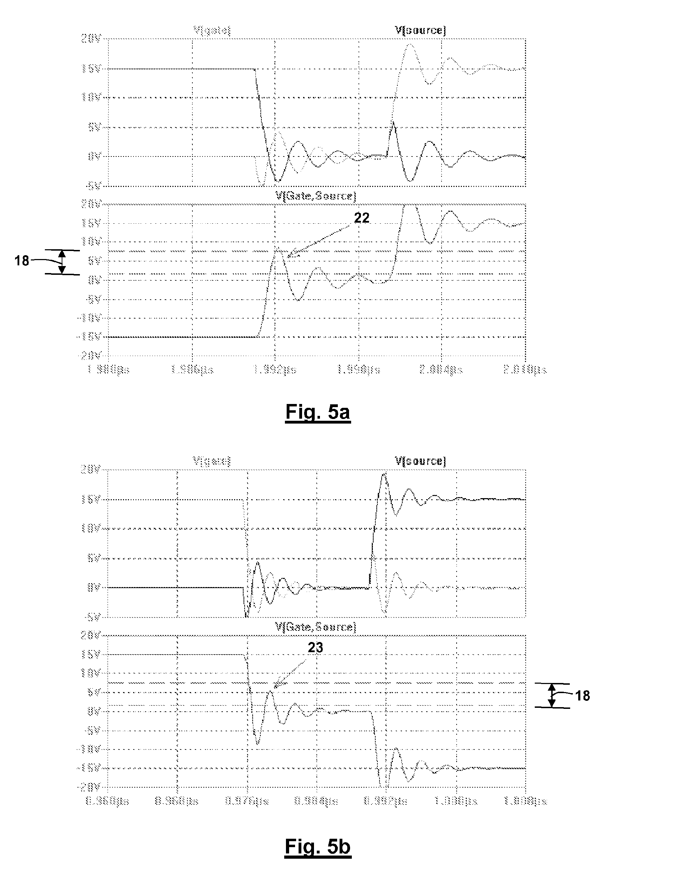

Die Potenzialverläufe gemäß Fig. 3 werden in der Praxis jedoch nicht realisiert, weil in **Fig. 4** skizzierte parasitäre Elemente in Form von Leitungsinduktivitäten 19 und 20 und einer Eingangskapazität 21 des Halbleiterleistungsschalters einen Schwingkreis ausbilden, der durch die steilen Potenzialübergänge an den Elektroden 4 und 5 zu Schwingungen angeregt werden kann. Die hieraus resultierenden Potenzialverläufe sind in **Fig. 5** dargestellt. Dabei ergeben sich ungewollte Potenzialschwingungen 22 und 23 bis in den Schaltbereich 18 des Halbleiterleistungsschalters 2 hinein, durch die dieser zwischenzeitlich erneut aus- und eingeschaltet wird, bevor er seinen gewünschten Schaltzustand endgültig erreicht. In Fig. 5 ist jeweils nur eine einzige solche Schwingung 22 bzw. 23 für den Einschaltvorgang (a)) bzw. den Ausschaltvorgang (b)) gezeigt. Es können aber jeweils auch mehrere solcher Schwingungen auftreten, die jeweils zu einem unerwünschten Schaltspiel des Halbleiterleistungsschalters 2 führen.

Grundsätzlich kann diesen unerwünschten Schaltspielen durch eine Minimierung der Leitungsinduktivität 19 und 20 und eine Synchronisierung der Potenzialübergänge an den Elektroden 4 und 5 begegnet werden. Um die Schaltspiele auf diese Weise jedoch sicher auszuschließen, ist ein ganz erheblicher Aufwand zu betreiben. Bei der vorliegenden Erfindung wird stattdessen der Potenzialübergang an der einen Elektrode zeitlich gedehnt und der Beginn des Potenzialübergangs an der anderen Elektrode gegenüber dem Potenzialübergang an der einen Elektrode verzögert, so dass der schnellere Potenzialübergang während des langsamen Potenzialübergangs erfolgt. Zudem wird diese Verzögerung abhängig davon festgelegt, ob der jeweilige Leistungsschalter 2 ein- oder ausgeschaltet wird. Im Ergebnis wird der Schaltbereich 18 des Leistungshalbleiterschalters 2 immer während des schnellen Potenzialübergangs an der anderen Elektrode durchfahren, ohne dass in seiner Folge auftretende Potenzialschwingungen diesen Schaltbereich nochmals erreichen und damit zu unerwünschten zusätzlichen Schaltspielen führen. Diesem Zweck dienen der Dehner 16 und der Verzögerer 17 die in Fig. 2 skizziert sind.

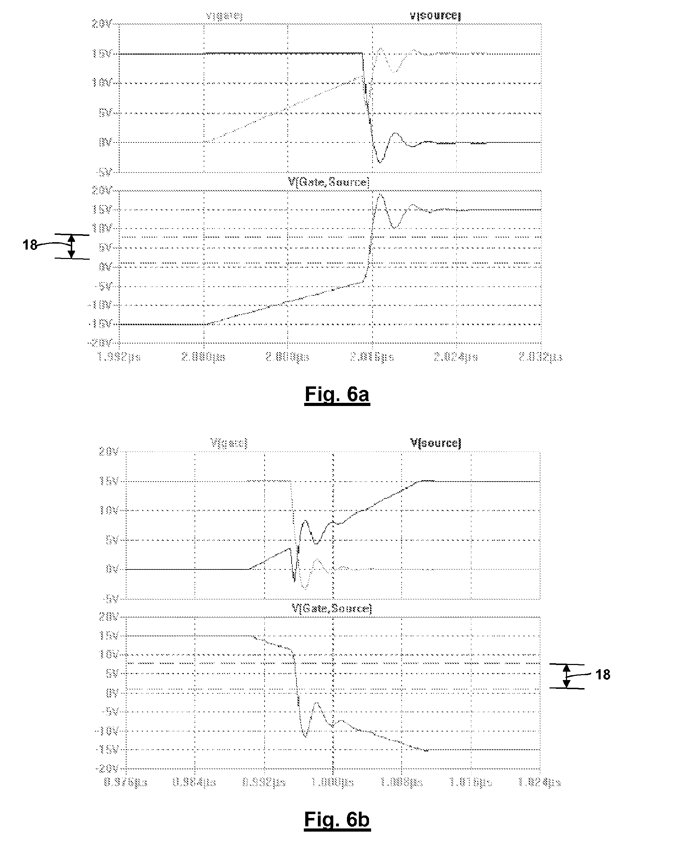

Die Funktionsweise dieser Maßnahmen ist in **Fig. 6** dargestellt, wobei hier aber anders als bei der Ausführungsform gemäß Fig. 2 der Potenzialübergang an der Steuerelektrode 5 (Source) gedehnt ist, während der Potenzialübergang an der Steuerelektrode 4 (Gate) verzögert ist. Der gedehnte Potenzialübergang regt seinerseits keine Potenzialschwingungen an und führt die Potenzialdifferenz in die Nähe des Schaltbereichs 18, bevor der schnellere Potenzialübergang an der Steuerelektrode (Gate) einsetzt und die Potenzialdifferenz schnell durch den Schaltbereich 18 hindurchführt. Hierdurch angeregte Potenzialschwingungen verlaufen außerhalb des Schaltbereichs 18.

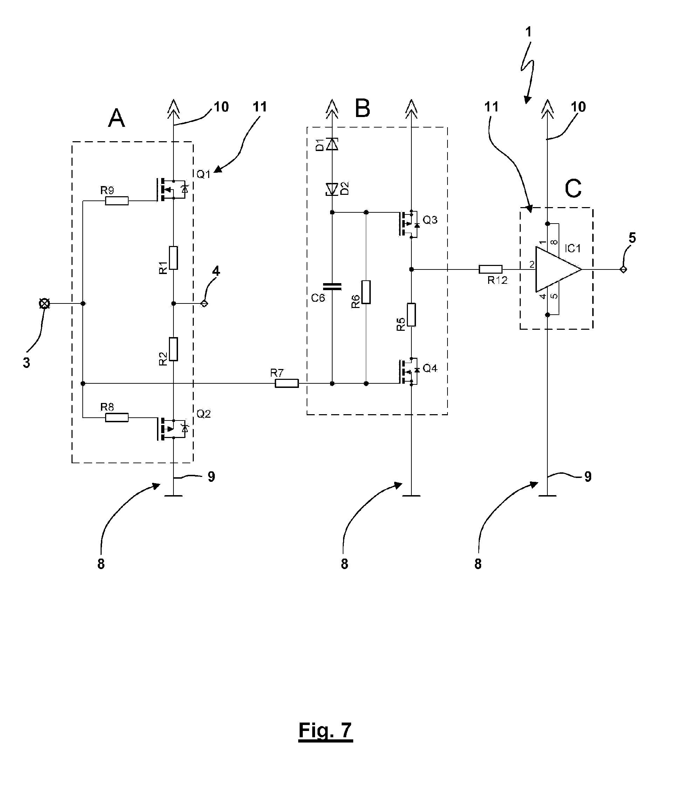

**Fig. 7** skizziert eine konkretere Treiberschaltung 1 zur Realisation der bevorzugten Potenzialübergänge gemäß Fig. 6, wobei hier der Leistungshalbleiterschalter, für den die Treiberschaltung 1 vorgesehen ist, selbst nicht dargestellt ist. Außerdem ist die Treiberschaltung 1 gemäß Fig. 7 wie diejenige gemäß Fig. 2 für einen gedehnten Potenzialübergang an der Steuerelektrode 4 (Gate) und einen verzögerten aber schnellen Potenzialübergang an der Bezugselektrode 5 (Source) vorgesehen. Gedanklich kann die Treiberschaltung 1 gemäß Fig. 7 in drei Blöcke A, B und C unterteilt werden. Ein Spannungsfolger A dient der Ansteuerung der Steuerelektrode 4. Der Spannungsfolger A weist eine Spannungsverstärkung kleiner 1 aber eine hohe Stromverstärkung auf. Widerstände R1 und R2 haben dabei die Aufgabe, den maximalen Ausgangsstrom des Spannungsfolgers A, d. h. den Ladestrom der Eingangskapazität des Halbleiterleistungsschalters, zu begrenzen. Über Gate-Widerstände R8 und R9 von Transistoren Q1 und Q2, die den Schaltern S1 und S2 gemäß Fig. 2 entsprechen, wird die Geschwindigkeit des Potenzialübergangs beim Umschalten der Steuerelektrode 4 zwischen den beiden Polen der Treiberversorgungsspannung eingestellt.

Die Bezugselektrode 5 wird über eine integrierte Treiberschaltung C angesteuert. Der Potenzialübergang an der Bezugselektrode soll beim Umschalten zwischen den Polen der Treiberversorgungsspannung 8 schnell erfolgen. Eine vorgeschaltete Phasenumkehrstufe B bewirkt einerseits die notwendige Invertierung des Steuersignals 3 gegenüber der Ansteuerung der Treiberschaltung C. Zum anderen verursacht sie die gewünschte Verzögerung, da die schnelle Treiberschaltung C erst dann schalten soll, wenn der Potenzialübergang an der Steuerelektrode 4 bereits teilweise erfolgt ist. Ein Kondensator C6 und Dioden D1 und D2 der Phasenumkehrstufe B ermöglichen eine Vorspannung am Gate des Transistors Q3. Hierdurch wird das Zeitintervall verkürzt, in dem beide Transistoren Q3 und Q4 leitend sind, und es können abgestimmte Verzögerungen für das Ein- und das Ausschalten des hier nicht dargestellten Halbleiterleistungsschalters eingestellt werden. Ein Widerstand R5 begrenzt den Strom durch die Transistoren Q3 und Q4 während der verbleibenden Überlappung.

### BEZUGSZEICHENLISTE

- 1 Treiberschaltung: Q4 Transistoren
- 2 Halbleiterleistungsschalter: R1 Widerstände
- 3 Steuersignal: R2 Widerstände
- 4 Steuerelektrode: R3 Widerstände
- 5 Bezugselektrode: R4 Widerstände
- 6 Treiberbaustein: R5 Widerstände
- 7 Treiberbaustein: R6 Widerstände
- 8 Treiberversorgungsspannung: R7 Widerstände
- 9 Pol: R8 Widerstände
- 10 Pol: R9 Widerstände
- 11 Schaltbrücke: D1 Dioden
- 12 Ansteuersignal: D2 Dioden
- 13 Ansteuersignal: IC1 Integrierte Schaltung
- 14: Invertierer
- 15: Invertierer
- 16: Dehner
- 17: Verzögerer
- 18: Schaltbereich
- 19: Leistungsinduktivität
- 20: Leistungsinduktivität
- 21: Eingangskapazität
- 22: Potenzialschwingung
- 23: Potenzialschwingung
- S1: Schalter
- S2: Schalter
- S3: Schalter
- S4: Schalter
- Q1: Transistoren
- Q1: Transistoren
- Q3: Transistoren
- Q4: Transistoren
- R1: Widerstände
- R2: Widerstände
- R3: Widerstände
- R4: Widerstände
- R5: Widerstände
- R6: Widerstände
- R7: Widerstände
- R8: Widerstände
- R9: Widerstände
- D1: Dioden
- D2: Dioden
- IC1: Integrierte Schaltung

## Patentansprüche

1. Verfahren zum Schalten eines Halbleiterleistungsschalters (2) in Abhängigkeit von einem digitalen Steuersignal (3), wobei einer Steuerelektrode (4) und einer Bezugselektrode (5) des Halbleiterleistungsschalters (2) jeweils einer von zwei Polen (9, 10) einer Treiberversorgungsspannung (8) zugeschaltet wird, **dadurch gekennzeichnet, dass** aufgrund jeder Änderung des digitalen Steuersignals (3) die Zuschaltung der beiden Pole (9, 10) der Treiberversorgungsspannung (8) zu der Steuerelektrode (4) einerseits und der Bezugselektrode (5) andererseits umgekehrt wird.

2. Verfahren nach Anspruch 1, **dadurch gekennzeichnet, dass** jeweils eine der Elektroden (4, 5) so zwischen den beiden Polen (9, 10) der Treiberversorgungsspannung (8) umgeschaltet wird, dass ein zeitlich gedehnter stetiger Potenzialübergang an dieser einen Elektrode (4, 5) resultiert.

3. Verfahren nach Anspruch 2, **dadurch gekennzeichnet, dass** die eine Elektrode (4, 5) so zwischen den beiden Polen (9, 10) der Treiberversorgungsspannung (8) umgeschaltet wird, dass ein linearer Potenzialübergang an dieser einen Elektrode (4, 5) resultiert.

4. Verfahren nach Anspruch 3, **dadurch gekennzeichnet, dass** der zeitlich gedehnte Potenzialübergang 3- bis 50-mal länger dauert als ein Potenzialübergang an der jeweils anderen Elektrode (4, 5) bei deren Umschalten zwischen den beiden Polen (9, 10) der Treiberversorgungsspannung (8).

5. Verfahren nach Anspruch 4, **dadurch gekennzeichnet, dass** der zeitlich gedehnte Potenzialübergang 5- bis 10-mal länger dauert als der Potenzialübergang an der jeweils anderen Elektrode (4, 5).

6. Verfahren nach einem der Ansprüche 2 bis 5, **dadurch gekennzeichnet, dass** der Beginn des kürzeren Potenzialübergangs an der jeweils anderen Elektrode (4, 5) gegenüber dem Beginn des zeitlich gedehnten Potenzialübergangs an der jeweils anderen Elektrode (4, 5) verzögert wird.

7. Verfahren nach Anspruch 6, **dadurch gekennzeichnet, dass** der Beginn des kürzeren Potenzialübergangs an der jeweils anderen Elektrode (4, 5) um 10 % bis 90 % der Dauer des zeitlich gedehnten Potenzialübergangs an der jeweils einen Elektrode (4, 5) verzögert wird.

8. Verfahren nach Anspruch 7, **dadurch gekennzeichnet, dass** der Beginn des kürzeren Potenzialübergangs an der jeweils anderen Elektrode um 20 % bis 80 % der Dauer des zeitlich gedehnten Potenzialübergangs an der jeweils einen Elektrode (4, 5) verzögert wird.

9. Verfahren nach mindestens einem der Ansprüche 1 bis 8, **dadurch gekennzeichnet, dass** die Potenzialübergänge an den beiden Elektroden (4, 5) so zeitlich aufeinander abgestimmt werden, dass mit der Potenzialdifferenz zwischen den beiden Elektroden (4, 5) ein aktiver Schaltbereich (18) des Halbleiterleistungsschalters (2) während des kürzeren Potenzialübergangs an der jeweils anderen Elektrode (4, 5) durchfahren wird.

10. Treiberschaltung (1) für einen Halbleiterleistungsschalter (2) zur Durchführung des Verfahrens nach einem der Ansprüche 1 bis 9, **gekennzeichnet durch** zwei Halbbrücken (11), die die Steuerelektrode (4) und die Bezugselektrode (5) des Halbleiterleistungsschalters (2) jeweils wechselweise mit den beiden Polen (9, 10) der Treiberversorgungsspannung (8) verbinden.

11. Treiberschaltung nach Anspruch 10, **dadurch gekennzeichnet, dass** eine der beiden Halbbrücken (11) bei einer Änderung des digitalen Steuersignals (3) so zwischen den beiden Polen (9, 10) der Treiberversorgungsspannung (8) umschaltet, dass an einer der Elektroden (4, 5) ein zeitlich gedehnter stetiger Potenzialübergang resultiert.

12. Treiberschaltung nach Anspruch 11, **dadurch gekennzeichnet, dass** die andere der beiden Halbbrücken (11) bei einer Änderung des digitalen Steuersignals (3) so zwischen den beiden Polen (9, 10) der Treiberversorgungsspannung (8) umschaltet, dass während des zeitlich gedehnten Potenzialübergangs an der einen Elektrode (4, 5) an der anderen Elektrode ein verzögerter, aber kürzerer Potenzialübergang resultiert.

13. Treiberschaltung nach Anspruch 12, **dadurch gekennzeichnet, dass** die Verzögerung beim Umschalten der jeweils anderen Schaltbrücke (11) so eingestellt ist, dass eine Potenzialdifferenz zwischen den Elektroden (4, 5) einen Schaltbereich (18) des Halbleiterleistungsschalters (2) während des kürzeren Potenzialübergangs an der jeweils anderen Elektrode (4, 5) durchläuft.

14. Treiberschaltung nach Anspruch 13, **dadurch gekennzeichnet, dass** die Verzögerung bei den beiden Richtungen des Umschaltens zwischen den Polen (9, 10) der Treiberversorgungsspannung (8) unterschiedliche Werte aufweist.

15. Treiberschaltung nach einem der Ansprüche 10 bis 14, **dadurch gekennzeichnet, dass** die eine Elektrode die Steuerelektrode (4) und die andere Elektrode die Bezugselektrode (5) des Halbleiterleistungsschalters (2) ist.
